# DEMANDE DE BREVET EUROPEEN

(11) **EP 0 541 463 A1**
(43) Date de publication de la demande: **12.05.1993**
(21) Numéro de dépôt: 92420393.8
(22) Date de dépôt: 02.11.1992
(51) Int. Cl.: G01R 29/027

(54) **Circuit de détection de durée d'alternances d'un signal d'horloge**

(30) Priorité: 06.11.1991 FR 9114020
(71) Demandeur: SGS-THOMSON MICROELECTRONICS S.A., F-94250 Gentilly (FR)
(72) Inventeur: Fournel, Richard, F-13530 Trets (FR)
(74) Mandataire: de Beaumont, Michel

(57) **Abrégé**

La présente invention concerne un circuit de détection du fait que chaque alternance d'un signal d'horloge (CLK) garde une durée inférieure ou supérieure à un seuil déterminé, comprenant des moyens (1, 2) de fourniture d'un signal de fréquence double de la fréquence d'horloge, et des moyens (C1, 5) pour déterminer si la durée d'une des périodes du signal de fréquence double devient supérieure ou inférieure à un seuil déterminé.

## Description

La présente invention concerne des circuits de détection de durée maximum ou minimum de chacune des demi -périodes d'un signal d'horloge.

Il est exposé dans la demande de brevet européen EP-A-0270410 de la demanderesse (inventeur : Alexis Marquot) qu'il peut être utile dans le cadre de circuits intégrés logiques de prévoir un circuit permettant de s'assurer de la présence permanente d'un signal d'horloge. Ceci est notamment utile dans le cadre des circuits intégrés comprenant des mémoires et un microprocesseur typiquement utilisés dans les cartes à mémoires portables.

Dans la demande de brevet susmentionnée, comme cela est illustré en figure 1 de la présente demande, on formé à partir du signal d'horloge CLK à tester deux signaux d'horloge interne à fréquence moitié en opposition CLK1 et CLK2 et l'on détecte si la durée à un niveau déterminé de l'un et l'autre de ces signaux CLK1 et CLK2 reste bien inférieure à une durée prédéterminée. Si ce n'est pas le cas, il est fourni un signal d'alarme qui peut déclencher des circuits d'inhibition du fonctionnement du circuit intégré. En effet, on sait alors que l'une des périodes de l'horloge est manquante, c'est-à-dire que le signal d'horloge s'est interrompu ou a été maintenu trop longtemps dans un état déterminé.

Ainsi, ce circuit détermine le fait qu'une période d'horloge présente une durée qui dépasse un seuil prédéterminé. On notera de plus dans ce circuit antérieur que la détection des durées maximales des signaux CLK1 et CLK2 est faite par des détecteurs (intégrateurs) distincts et donc que l'on n'a pas nécessairement la même précision sur la détection de CLK1 et de CLK2.

Le circuit susmentionné a donné des résultats satisfaisants. Toutefois, la demanderesse a noté, notamment dans des applications à des cartes à mémoire, que le fonctionnement du circuit risque de devenir aléatoire non pas seulement si l'horloge est interrompue ou devient trop lente, mais aussi si son rapport cyclique (c'est-à-dire la durée de chaque demi-période de l'horloge) dépasse certaines limites. En outre, le fait de surveiller la durée de chaque demi-période peut aussi permettre d'éviter certaines actions d'un fraudeur éventuel qui remplacerait le signal d'horloge périodique par un signal de même période mais de rapport cyclique différent, ce qui lui permettrait éventuellement d'analyser des réactions du circuit pendant le maintien plus long du signal d'horloge à un niveau déterminé.

En conséquence, un objet de la présente invention est de prévoir des circuits permettant de détecter le fait que chacune des alternances d'un signal d'horloge présente une durée qui reste supérieure ou respectivement inférieure à un seuil déterminé.

Pour atteindre ces objets, la présente invention prévoit un circuit de détection du fait que chaque alternance d'un signal d'horloge garde une durée inférieure ou supérieure à un seuil déterminé, comprenant des moyens de fourniture d'un signal de fréquence double de la fréquence d'horloge, et des moyens pour déterminer si la durée d'une des périodes du signal de fréquence double devient supérieure ou inférieure à un seuil déterminé.

Selon un mode de réalisation de la présente invention, les moyens de fourniture du signal de fréquence double comprennent une porte OU Exclusif et un circuit de retard, le signal d'horloge étant fourni directement à la première entrée de la porte OU et étant fourni à la deuxième entrée de cette porte OU par l'intermédiaire du circuit de retard.

Selon un mode de réalisation de la présente invention, la durée de retard du circuit de retard est nettement inférieure à la demi-période du signal d'horloge.

Selon un mode de réalisation de la présente invention, les moyens de détermination de durée comprennent des moyens de charge, ou respectivement de décharge, rapide d'un condensateur pendant ladite durée de retard, des moyens de décharge, ou respectivement de charge à courant constant de ce condensateur pendant la durée restante de chaque demi-période, et des moyens pour comparer la tension du condensateur à un seuil déterminé.

Ces objets, caractéristiques et avantages ainsi que d'autres de la présente invention seront exposés en détail dans la description suivante de modes de réalisation particuliers faite en relation avec les figures jointes parmi lesquelles :
la figure 1, qui représente un chronogramme destiné à illustrer le fonctionnement d'un circuit antérieur, a été décrite précédemment ;
la figure 2 représente un schéma sous forme de blocs d'un mode de réalisation de la présente invention ;
la figure 3 représente un chronogramme destiné à expliquer le fonctionnement d'un circuit selon la présente invention ;
la figure 4 est un schéma détaillé d'un mode de réalisation de la présente invention ; et
la figure 5 est un schéma détaillé d'un autre mode de réalisation de la présente invention.

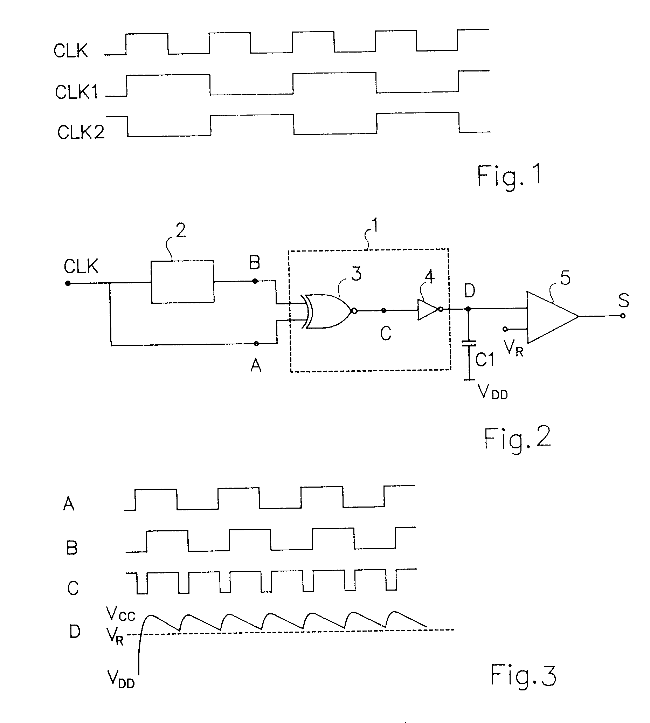

La figure 2 représente de façon schématique un mode de réalisation d'un circuit mettant en oeuvre la présente invention. Le signal d'horloge à vérifier, CLK, est envoyé à une première entrée d'une porte OU Exclusif 1 dont la deuxième entrée reçoit le signal CLK retardé d'une durée nettement inférieure à sa demi-période par l'intermédiaire d'un circuit de retard 2. La porte OU Exclusif 1 est représentée sous la forme de la combinaison en série d'une porte NON OU Exclusif 3 et d'un inverseur 4. Cette représentation a été choisie d'une part parce qu'elle permet de mieux illustrer des signaux obtenus, d'autre part parce qu'elle correspond à la réalisation habituelle d'une porte OU Exclusif en technologie CMOS. La sortie de la porte OU est appliquée à une borne d'un condensateur C1 dont l'autre borne est à une tension de référence VDD, correspondant au niveau bas du signal d'horloge, par exemple la masse. La tension aux bornes du condensateur C1 déclenche le basculement d'un inverseur ou d'un comparateur 5 dont la sortie S fournit le signal de détection recherché.

Le fonctionnement du circuit selon la présente invention sera expliqué en relation avec la figure 3 dans laquelle les courbes A, B, C et D représentent les tensions apparaissant respectivement à l'entrée directe, à l'entrée retardée, et à la sortie de la porte NON OU Exclusif 3, ainsi que sur le condensateur C1.

La courbe A représente un signal d'horloge régulier. La courbe B représente ce même signal d'horloge retardé par le circuit 2. La courbe C représente de courtes impulsions négatives qui commencent au début de chaque transition du signal d'entrée CLK. La durée de ces impulsions négatives est fixe et déterminée par le circuit de retard 2. En conséquence, la durée des alternances positives du signal C est caractéristique de la durée de chaque alternance du signal d'horloge A. Le condensateur C1 se charge rapidement jusqu'à la tension d'alimentation haute VCC pendant les alternances négatives du signal C (rendues positives par l'inverseur 4) puis se décharge progressivement pendant les alternances positives de ce signal. La tension aux bornes du condensateur C1 est comparée à un seuil VR par un comparateur 5. Comme cela est indiqué en figure 3, courbe D, ce seuil VR est choisi légèrement inférieur à la tension minimale qu'atteint normalement le condensateur C1 en fin de décharge quand le signal d'horloge est suffisamment rapide.

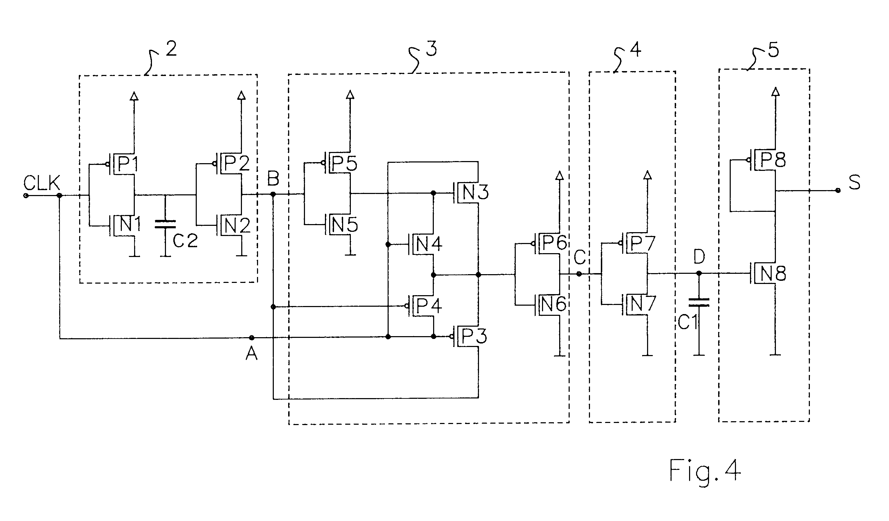

La figure 4 représente un mode de réalisation pratique en technologie CMOS du circuit représenté sous forme de blocs en figure 2. Dans la figure 4, les connexions se terminant par une flèche indiquent des connexions vers une tension haute VCC et les connexions se terminant par un trait horizontal indiquent des connexions vers une tension basse, VDD ou la masse.

Le circuit de retard 2 est constitué d'un premier inverseur comprenant un transistor MOS à canal N, N1, et un transistor MOS à canal P, P1, chargeant un condensateur C2. La tension aux bornes du condensateur C2 est recueillie par un deuxième inverseur P2-N2 qui fournit un signal correspondant à celui sur la borne B de la figure 2.

Le circuit de porte NON OU Exclusif 3 comprend deux transistors MOS à canal N et P, N3 et P3, en série. Entre les grilles des transistors N3 et P3 sont connectés des transistors MOS à canal N et P, N4 et P4, en série. Les drains des transistors N4, P4, N3, P3 sont interconnectés.

La source du transistor N3 est reliée aux grilles des transistors N4 et P3 qui reçoivent le signal A. La grille du transistor P4 et la source du transistor P3 reçoivent le signal B et la grille du transistor N3 reçoit le signal B inversé par un inverseur P5-N5. Toute autre configuration de porte OU pourra être utilisée. Un inverseur P6-N6 fournit un signal correspondant à celui référencé C en figure 2. Ce signal est envoyé à un inverseur P7-N7 correspondant à l'inverseur 4 illustré en figure 2 et chargeant ou déchargeant le condensateur C1. La prévision des deux inverseurs P6-N6 et P7-N7 pourrait paraître redondante. Elle est destinée à assurer une décharge à courant relativement constant du condensateur C1 quand le signal C est à haut niveau.

Le circuit 5 de comparaison à un seuil peut être simplement constitué de l'assemblage de transistors N8 et P8 connectés de la façon représentée. La grille du transistor N8 reçoit le signal D, sa source est connectée à la tension VDD, son drain au drain du transistor P8 dont la source est connectée à la source de tension haute. La grille du transistor P8 est connectée à la borne commune des transistors P8 et N8 qui constitue également la borne de sortie S. Le transistor P8 a la fonction d'un générateur de courant et le transistor N8 sert de charge. Le seuil de basculement (la tension VR) est fixé par les rapports dimensionnels de ces transistors.

D'autres montages peuvent être utilisés par exemple un simple inverseur dont le seuil est déterminé en fonction des tailles des transistors, ou un comparateur avec tension de référence.

Dans la réalisation des figures 2 et 4, on a décrit un circuit par lequel on détermine si les alternances de la tension d'horloge gardent une durée inférieure à un seuil déterminé.

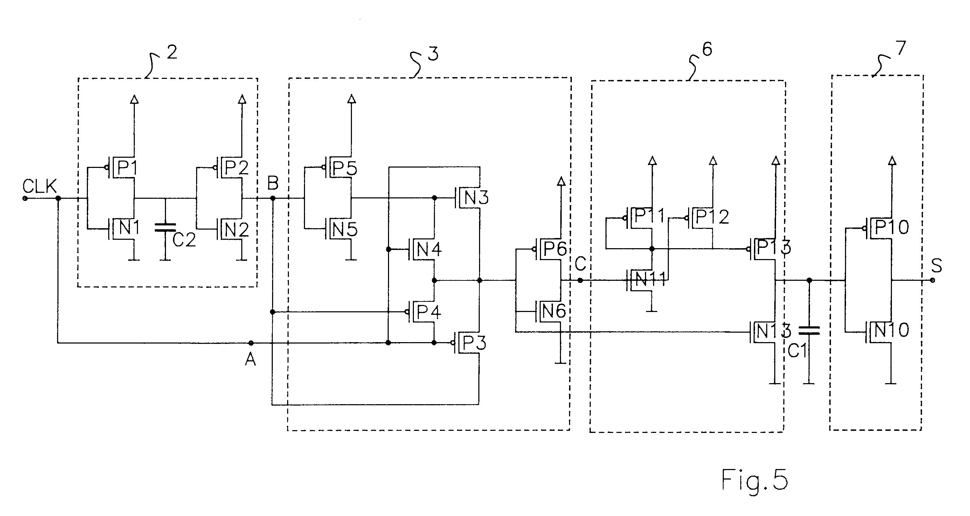

Dans une variante de réalisation, illustrée en figure 5, on détermine si ces alternances ont une durée supérieure à un seuil déterminé.

On retrouve dans le mode de réalisation de la figure 5 des blocs 2 et 3 identiques à ceux de la figure 4. Toutefois, cette fois-ci, au lieu que la tension de sortie de la porte NON OU Exclusif 3 au point C soit fournie au condensateur C1 par l'intermédiaire d'un inverseur, elle est appliquée à ce condensateur par l'intermédiaire d'un circuit de charge à courant constant 6, ce qui fait que l'on déterminera cette fois-ci des durées de charge et plus des durées de décharge. En figure 5, le fait que la tension sur le condensateur C1 dépasse un niveau prédéterminé est détecté par un simple inverseur 7 comprenant des transistors N10 et P10. Le circuit de charge à courant constant comprend, dans le mode de réalisation représenté, un transistor MOS à canal N, N11, dont la source est connectée à la masse et dont le drain est connecté à la tension haute par l'intermédiaire d'un transistor MOS à canal P, P11. La grille du transistor P11 est reliée à son drain. La grille du transistor N11 est reliée à la grille d'un transistor MOS à canal P, P12, dont la source est à la tension haute et dont le drain est à la borne commune des transistors N11 et P11. Cette borne commune est également reliée à la grille d'un transistor MOS à canal P, P13, dont la source est reliée à la tension haute et dont le drain est relié à la masse par l'intermédiaire d'un transistor MOS à canal N, N13. Le transistor N13 a sa grille reliée à l'entrée de l'inverseur P6-N6. La borne commune des transistors N13 et P13 constitue la sortie du circuit qui charge à courant constant le condensateur C1 pendant les phases à niveau haut du signal C. Dans cette configuration, pendant les phases à niveau bas du signal C, le condensateur C1 se décharge rapidement.

La réalisation des circuits illustrés en figures 4 et 5 est susceptible de nombreuses variantes qui apparaîtront à l'homme de l'art, la caractéristique fondamentale de l'invention résidant dans la fourniture de signaux caractéristiques de la durée de chaque alternance d'un signal d'horloge pour vérifier que ces alternances gardent une durée inférieure ou supérieure à un seuil déterminé. On notera qu'un avantage de la présente invention est que les alternances positive et négative du signal d'horloge CLK sont déterminées par des mesures effectuées sur un même condensateur (C1) et que l'on a donc une même précision sur ces mesures.

## Revendications

1. Circuit de détection du fait que chaque alternance d'un signal d'horloge garde une durée inférieure ou supérieure à un seuil déterminé, caractérisé en ce qu'il comprend :
des moyens (1, 2) de fourniture d'un signal de fréquence double de la fréquence d'horloge, et
des moyens (C1, 5) pour déterminer si la durée d'une des périodes du signal de fréquence double devient supérieure ou inférieure à un seuil déterminé.

2. Circuit de détection selon la revendication 1, caractérisé en ce que les moyens de fourniture du signal de fréquence double comprennent une porte OU Exclusif (1) et un circuit de retard (2), le signal d'horloge étant fourni directement à la première entrée de la porte OU et étant fourni à la deuxième entrée de cette porte OU par l'intermédiaire du circuit de retard.

3. Circuit de détection selon la revendication 1, caractérisé en ce que la durée de retard du circuit de retard est nettement inférieure à la demi-période du signal d'horloge.

4. Circuit selon la revendication 3, caractérisé en ce que les moyens de détermination de durée comprennent des moyens de charge, ou respectivement de décharge, rapide d'un condensateur (C1) pendant ladite durée de retard, des moyens de décharge, ou respectivement de charge, à courant constant de ce condensateur pendant la durée restante de chaque demi-période, et des moyens (5) pour comparer la tension du condensateur à un seuil déterminé.
